# EUROPEAN PATENT APPLICATION

(11) **EP 3 950 258 A1**
(43) Date of publication of application: **09.02.2022**
(21) Application number: 21189057.9
(22) Date of filing: 02.08.2021
(51) Int. Cl.: B29C 45/00, B29C 45/27, B29C 45/33, B29C 45/44, G02F 1/1333, B29L 12/00, B29L 31/34

(54) **RESIN MOLDED ARTICLE MANUFACTURING METHOD AND DISPLAY DEVICE**

(30) Priority: 07.08.2020 JP 2020135274
(71) Applicant: Funai Electric Co., Ltd., Daito, Osaka, 574-0013 (JP)
(72) Inventor: KIMURA, Takeshi, Daito, Osaka, 574-0013 (JP)
(74) Representative: Global IP Europe Patentanwaltskanzlei

(57) **Abstract**

A resin molded article manufacturing method comprises forming a cavity having a shape corresponding to a resin molded article by bringing a plurality of resin molding dies into contact with each other, and forming the resin molded article by injecting a resin directly from a resin ejection port into a resin injection gate and filling the cavity with the resin. The forming of the resin molded article includes filling the cavity with the resin while changing a flow of the resin that is headed from the resin injection gate directly toward the cavity by a resin flow changing section that is provided opposite the resin injection gate.

## Description

This application claims priority to Japanese Patent Application No. 2020-135274 filed on August 7, 2020.

### BACKGROUND

### Field of the Invention

The present invention generally relates to a resin molded article manufacturing method and to a display device. More specifically, the present invention relates to a resin molded article manufacturing method comprising a step of forming a resin molded article.

### Background Information

A method for manufacturing a resin molded article comprises a step of forming the resin molded article (see, JP 2011-240508 A, for example).

JP 2011-240508 A discloses a cabinet manufacturing method (a method for manufacturing a resin molded article) for a thin display device, which comprises a step of forming a front cabinet (resin molded article). The step of forming the front cabinet above includes a step of forming a cavity corresponding to the front cabinet between a fixed-side die and a movable-side die. Here, the fixed-side die and the movable-side die are opposite each other in the movement direction of the movable-side die. Also, a product exterior portion is disposed on the movable-side die. The product exterior portion is a surface of the movable-side die that forms an exterior surface of the front cabinet.

The cabinet manufacturing method of JP 2011-240508 A comprises a step of filling the cavity with resin by ejecting the resin directly into the cavity from a resin ejection port of a hot runner. Here, the fixed-side die is provided with the resin ejection port at a position opposite the product exterior portion.

### SUMMARY

However, with the cabinet manufacturing method of JP 2011-240508 A, the resin ejected from the hot runner directly hits the product exterior portion of the opposing movable-side die (i.e., the portion corresponding to the exterior surface of the product). In this case, the resin that is ejected from the hot runner and hits the product exterior portion (i.e., the portion corresponding to the exterior surface of the product) may rebound, which can cause appearance defects around the part of the product exterior portion that is hit by the resin. When this happens, a problem with the cabinet manufacturing method of JP 2011-240508 A is that appearance defects cannot be reduced unless the molding conditions are changed, such as reducing the injection speed at which the resin is ejected from the hot runner, or enlarging the cavity space. Also, if the molding conditions are changed, this can impose a heavy burden on the operator in order to change the molding conditions and set the optimal molding conditions.

Here, the following can be considered as the cause of the appearance defects around the part of the product exterior portion that is hit by the resin. That is, the resin may not sufficiently fill in around the part of the product exterior portion that is hit by the resin due to the resin rebounding, and that the density of the resin may be uneven within the cavity. Because the density of the resin in the cavity is uneven, appearance defects may occur, in which the exterior surface of the product turns white due to the difference in shrinkage of the resin, or a pattern matching the rebound flow of the resin appears on the exterior surface of the product.

One object is to provide a resin molded article manufacturing method with which appearance defects can be reduced without changing the molding conditions and a display device.
(1) In view of the state of the known technology and in accordance with a first aspect of the present invention, a resin molded article manufacturing method comprises forming a cavity having a shape corresponding to a resin molded article by bringing a plurality of resin molding dies into contact with each other, and forming the resin molded article by ejecting a resin directly from a resin ejection port into a resin injection gate and filling the cavity with the resin. The forming of the resin molded article includes filling the cavity with the resin while changing a flow of the resin that is headed from the resin injection gate directly toward the cavity by a resin flow changing section that is provided opposite the resin injection gate.
   With the resin molded article manufacturing method according to the first aspect, the forming of the resin molded article is provided with filing the cavity with the resin while changing the flow of the resin that is headed from the resin injection gate directly toward the cavity by the resin flow changing section that is provided opposite the resin injection gate. Consequently, the resin ejected from the resin ejection port hits the opposing resin flow changing section, which changes the resin flow. Thus, when the resin ejected from the resin ejection port reaches the exterior surface, the resin will have less momentum as compared to a case in which the ejected resin reaches the exterior surface directly, and therefore rebound of the resin can be reduced in the cavity. Therefore, the cavity can be filled with the resin while reducing unevenness in the density of the resin in the cavity, so there will be fewer appearance defects such as whitening of the exterior surface due to the difference in the shrinkage of the resin, an appearance of a pattern on the exterior surface that matches the rebound flow of the resin, etc. As a result, appearance defects can be reduced by the resin flow changing section without changing the molding conditions.
(2) In accordance with a preferred embodiment according to the resin molded article manufacturing method mentioned above, the filling of the cavity with the resin includes branching the flow of the resin that is injected from the resin injection gate by the resin flow changing section. With this configuration, the amount of resin can be dispersed by branching the resin flow, so the kinetic energy of each branched resin flow can be reduced as compared to the original resin flow. As a result, the momentum of each branched resin flow can be reduced as compared to the original resin flow, so the rebounding of the resin in the cavity can be further suppressed.
(3) In accordance with a preferred embodiment according to any one of the resin molded article manufacturing methods mentioned above, the filling of the cavity with the resin includes branching the flow of the resin that is injected from the resin injection gate in two or more directions. The two or more directions intersect a resin injection direction of the resin that is injected from the resin injection gate by the resin flow changing section. With this configuration, every time the branching of the resin flow is increased, the amount of resin can be dispersed by the amount of the increase in the branching of the resin flow. Therefore, the kinetic energy of each branched resin flow can be further reduced as compared with the original resin flow, by the amount in which the branching of the resin flow is increased. As a result, the momentum of each branched resin flow can be further reduced as compared with the original resin flow, so the rebounding of the resin within the cavity can be further suppressed.
(4) In accordance with a preferred embodiment according to any one of the resin molded article manufacturing methods mentioned above, the forming of the cavity includes bringing a movable die provided with an exterior surface forming section that is configured to form an exterior surface of the resin molded article, a slide die provided with the resin flow changing section, and a fixed die into contact with each other, and the branching of the flow of the resin includes branching the resin by changing the flow of the resin that is injected from the resin injection gate by the resin flow changing section of the slide die. With this configuration, the resin flow changing section is provided to the slide die that is separate from the fixed die and the movable die. Thus, when the resin molded article is parted from the die, the slide die can be slid to remove the resin flow changing section from the resin molded article, so the resin molded article can be easily parted from the die without being caught by the resin flow changing section.
(5) In accordance with a preferred embodiment according to any one of the resin molded article manufacturing methods mentioned above, the forming of the resin molded article includes injecting the resin from the resin injection gate, and forming a gate formation portion between the resin flow changing section and the resin injection gate, as a non-exterior portion that is disposed inside of the resin molded article by making the resin flow toward the resin flow changing section. With this configuration, even if rebound occurs at the gate formation portion, there will be no appearance defects in the resin molded article because the gate formation portion is a non-exterior portion, so the appearance of the resin molded article can be kept good.
(6) In accordance with a preferred embodiment according to any one of the resin molded article manufacturing methods mentioned above, the filling of the cavity with the resin further includes filling the cavity with the resin while changing the flow of the resin that is headed from the resin injection gate directly toward the cavity by the resin flow changing section in a state in which the slide die is attached to the movable die and the fixed die, with the resin flow changing section of the slide die having a width that is greater than a width of the gate formation portion in a direction perpendicular to a resin injection direction of the resin. With this configuration, the resin flow toward the exterior surface forming section after branching can be diverted by the width of the resin flow changing section, so the momentum of the resin flow after branching is further reduced.
(7) In accordance with a preferred embodiment according to any one of the resin molded article manufacturing methods mentioned above, the filling of the cavity with the resin further includes filling the cavity with the resin while changing the flow of resin that is headed from the resin injection gate directly toward the cavity by the resin flow changing section in a state in which the slide die is attached to the movable die and the fixed die, with the resin flow changing section of the slide die having a height that is greater than a height of the gate formation portion in a resin injection direction of the resin. With this configuration, the length of the flow path of the resin going toward the exterior surface forming section after branching can be increased by the height of the resin flow changing section, so the momentum of the resin flow after branching can be further reduced.
(8) In accordance with a preferred embodiment according to any one of the resin molded article manufacturing methods mentioned above, the filling of the cavity with the resin further includes branching the resin both toward one side along a specific direction of a rib portion that is formed as a non-exterior portion and extends in the specific direction, and toward the other side that is in an opposite direction from the specific direction by the resin flow changing section. With this configuration, the rib portion can be used to branch the resin flow, so the structure of the resin molding die can be less complex than when a dedicated structure is provided for branching the resin flow.
(9) In accordance with a preferred embodiment according to any one of the resin molded article manufacturing methods mentioned above, the forming of the resin molded article includes forming a housing of a display device as the resin molded article. With this configuration, the housing of the display device with fewer appearance defects can be obtained by the resin flow changing section without changing the molding conditions.
(10) In view of the state of the known technology and in accordance with a second aspect of the present invention, a display device comprises a display module including a display that is configured to display images, and a resin housing holding the display module. The resin housing includes an exterior section with an exterior surface facing outside of the resin housing, and an interior section with an inner surface facing inside of the resin housing. The interior section has a gate formation portion with a first surface and a second surface oppositely facing away from the first surface, the second surface of the gate formation portion being disposed spaced apart from the exterior surface via a space portion of the resin housing.
   With the display device according to the second aspect, a cavity corresponding to the resin housing is filled with resin while changing the resin flow by a resin flow changing section forming the space portion of the resin housing. Consequently, the resin ejected from a resin ejection port hits the opposing resin flow changing section, which changes the resin flow. This reduces the momentum of the resin ejected from the resin ejection port, so the rebound of the resin inside the cavity can be reduced. Therefore, the cavity can be filled with the resin in a state in which there is less unevenness in the density of the resin in the cavity, so there will be fewer appearance defects, such as whitening of the exterior surface due to the difference in the shrinkage of the resin, an appearance of a pattern on the exterior surface that matches the rebounded resin flow, etc. As a result, a display device with fewer appearance defects can be obtained merely by forming the space portion by the resin flow changing section without changing the molding conditions.
(11) In accordance with a preferred embodiment according to the display device mentioned above, the second surface is disposed between the first surface and the exterior surface in a direction in which the gate formation portion extends.
(12) In accordance with a preferred embodiment according to any one of the display devices mentioned above, the interior section has a rib portion that extends from the inner surface and is connected to the gate formation portion, the rib portion having an aperture that forms the space portion of the resin housing.
(13) In accordance with a preferred embodiment according to any one of the display devices mentioned above, the second surface includes an undercut surface.
(14) In accordance with a preferred embodiment according to the display device mentioned above, the space portion of the resin housing has a width that is greater than a width of the gate formation portion in a width direction perpendicular to a direction in which the gate formation portion extends. With this configuration, the resin flow changing section that matches the space portion of the above-mentioned width can divert the flow of the resin toward the exterior surface forming section after branching by the width of the resin flow changing section, so the momentum of the resin flow after branching can be further reduced.
(15) In accordance with a preferred embodiment according to any one of the display devices mentioned above, the space portion of the resin housing has a height that is greater than a height of the gate formation portion in a direction in which the gate formation portion extends. With this configuration, the resin flow changing section that matches the space portion of the above-mentioned height can increase the length of the flow path of the resin going toward the exterior surface forming section after branching by the height of the resin flow changing section, so the momentum of the resin flow after branching can be further reduced.
(16) In accordance with a preferred embodiment according to any one of the display devices mentioned above, the first surface of the gate formation portion is configured to face with a resin injection gate while molding the resin housing.
(17) In accordance with a preferred embodiment according to any one of the display devices mentioned above, the first surface and the second surface are disposed away from each other in a resin injection direction for molding the resin housing.
(18) In accordance with a preferred embodiment according to any one of the display devices mentioned above, the space portion of the resin housing is formed by filling a cavity corresponding the resin housing with resin while changing a flow of the resin by a resin flow changing section.
(19) In accordance with a preferred embodiment according to any one of the display devices mentioned above, the second surface is disposed directly opposite the inner surface via the space portion of the resin housing.
(20) In accordance with a preferred embodiment according to any one of the display devices mentioned above, the gate formation portion has a thickness that is greater than a thickness of the rib portion.

The present invention provides a display device and a resin molded article manufacturing method with which appearance defects can be reduced, without changing the molding conditions.

### BRIEF DESCRIPTION OF THE DRAWINGS

Referring now to the attached drawings which form a part of this original disclosure:
FIG. 1 is a perspective view of a display device according to first to third embodiments;
FIG. 2 is a side elevational view of the display device according to the first to third embodiments;
FIG. 3 is a rear elevational view of a front housing of the display device according to the first to third embodiments;
FIG. 4 is a detailed cross-sectional view of a Z portion of the front housing in FIG. 3;
FIG. 5 is a normal view of a periphery of a space portion of the display device according to the first embodiment;
FIG. 6 is a flowchart showing a method for manufacturing the front housing according to the first embodiment;
FIG. 7 is a flowchart showing a cavity forming process according to the first embodiment;
FIG. 8 is a flowchart showing a front housing molding process according to the first embodiment;
FIG. 9 is a schematic view showing a state in which a movable die and a slide die are moved toward a first fixed die and a second fixed die in the method for manufacturing the front housing according to the first embodiment;
FIG. 10 is a schematic diagram showing a state in which a cavity is formed by abutting a first fixed die, a second fixed die, a movable die, and a slide die in the method for manufacturing the front housing according to the first embodiment;
FIG. 11 is a schematic view showing a state in which the cavity is filled with resin while the resin flow is changing by a resin flow changing section in the method for manufacturing the front housing according to the first embodiment;
FIG. 12 is a schematic view showing a state in which a gate formation portion is formed in the method for manufacturing the front housing according to the first embodiment;
FIG. 13 is a cross-sectional view taken along XIII-XIII line in FIG. 12;
FIG. 14 is a schematic view showing a state in which the resin fills up to an exterior surface forming section in the method for manufacturing the front housing according to the first embodiment;
FIG. 15 is a perspective view showing the periphery of the space portion of the front housing formed by the method of manufacturing the front housing according to the first embodiment;
FIG. 16 is a schematic view showing a state in which a cavity is filled with resin ejected from a cold runner in a method for manufacturing a front housing according to a second embodiment;
FIG. 17 is a perspective view of a periphery of a space portion of a front housing formed by a method for manufacturing the front housing according to a third embodiment; and
FIG. 18 is a plan view showing the periphery of the space portion of the front housing formed by the method for manufacturing the front housing according to the third embodiment.

### DETAILED DESCRIPTION OF EMBODIMENTS

Selected embodiments will now be explained with reference to the drawings. It will be apparent to those skilled in the art from this disclosure that the following descriptions of the embodiments are provided for illustration only and not for the purpose of limiting the invention as defined by the appended claims.

### FIRST EMBODIMENT

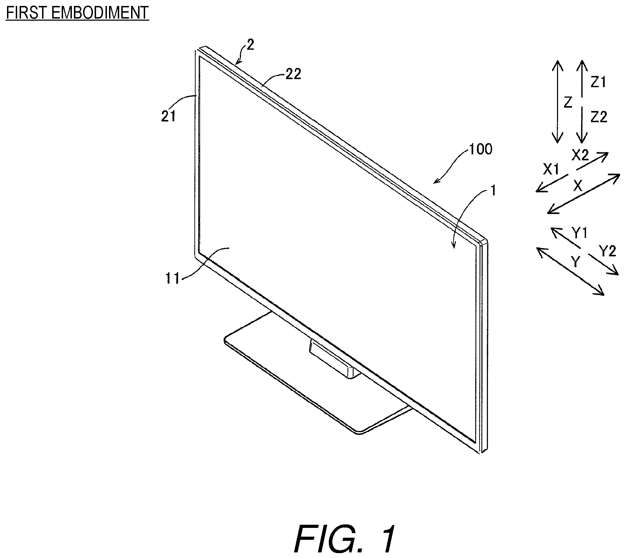

The configuration of a display device 100 will be described with reference to FIGS. 1 to 5. The display device 100 is an LCD television set. The display device 100 may be an organic EL (electroluminescence) television instead of an LCD television.

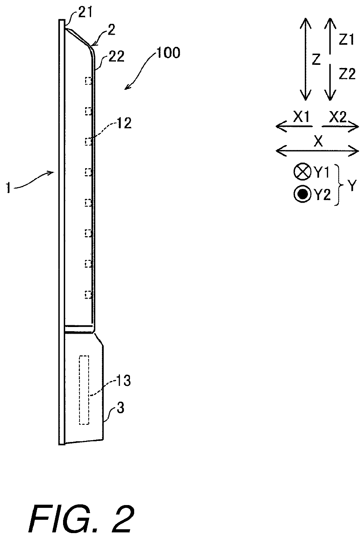

As shown in FIGS. 1 and 2, the display device 100 comprises a display module 1, a housing 2 (e.g., a resin housing), and a rear cover 3.

The display module 1 has the function of displaying images. The display module 1 includes a display unit 11 (e.g., a display), a light source 12, and a substrate 13. The display unit 11 is configured to display video or images using light from the light source 12. The display unit 11 includes a liquid crystal cell and a plurality of pixels. The pixels are configured to display video or images by varying the transmittance of the light emitted from the light source 12. The light source 12 is configured to irradiate the display unit 11 with light. The light source 12 includes a plurality of LEDs (light emitting diodes) disposed on the back side of the display unit 11. Specifically, in the illustrated embodiment, the LEDs are arranged in a matrix and disposed directly behind the display unit 11 to form a direct-lit backlight. However, the LEDs can be arranged along an edge of the display unit 11 to form an edge-lit backlight. The substrate 13 has a control circuit. The substrate 13 is configured such that a video signal is outputted to the display unit 11 by the control circuit.

The rear cover 3 is made of a resin material such as polystyrene. The rear cover 3 covers the substrate 13.

The housing 2 is configured to accommodate the display module 1 and so forth. More specifically, the housing 2 includes a front housing 21 and a rear housing 22. Here, the direction in which the front housing 21 and the rear housing 22 are arranged relative to each other is an X direction, the front housing 21 side in the X direction is an X1 direction, and the rear housing 22 side in the X direction is an X2 direction. The direction perpendicular to the X direction in the horizontal direction of the display device 100 is a Y direction, one side (a left side) in the Y direction is a Y1 direction, and the other side (a right side) in the Y direction is a Y2 direction. The direction perpendicular to the X direction and the Y direction is a Z direction, one side in the Z direction is a Z1 direction (an upward direction), and the other side in the Z direction is a Z2 direction (a downward direction). The front housing 21 is an example of the "housing" of the present disclosure.

The front housing 21 is a resin molded article made of a resin material. The front housing 21 is configured to accommodate the display module 1. The front housing 21 supports the display unit 11. Also, the front housing 21 has an opening through which the display surface of the display unit 11 is exposed. Thus, the front housing 21 has a frame shape as viewed from front of the display device 100. The rear housing 22 is made of sheet metal. The rear housing 22 is attached to the front housing 21 from the back side. In the illustrated embodiment, the rear housing 22 is made of sheet metal. However, the rear housing 22 can be a resin molded article made of a resin material. In the illustrated embodiment, as shown in FIG. 2, when the front housing 21 is attached to the rear housing 22, an interior space of the display device 100 is formed between the front housing 21 and the rear housing 22, in which the display unit 11 and the light source 12 are disposed.

### Front Housing

The front housing 21 will now be described in detail.

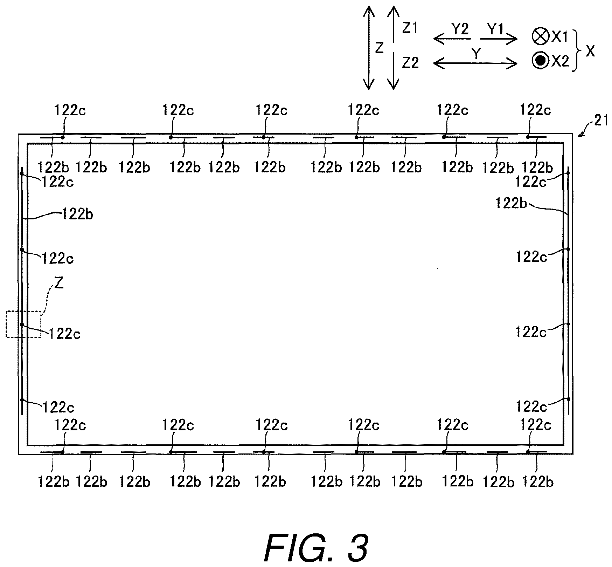

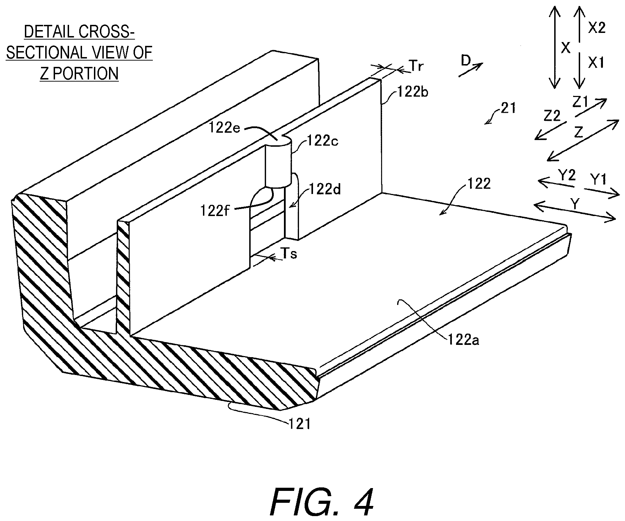

As shown in FIGS. 3 and 4, the front housing 21 has an exterior section with an exterior surface 121 and an interior section with an inner surface 122. The exterior surface 121 is a surface facing outside of the housing 2. That is, the exterior surface 121 is the surface of the front housing 21 that is visible to the user of the display device 100. In particular, the exterior section exposes outside of the display device 100 while the front housing 21 is attached to the rear housing 22. The exterior surface 121 has a front surface that forms a frontmost surface of the housing 2 and faces forward (the X1 direction), and four outside surfaces that forms outermost surfaces of the housing 2 and faces outward relative to the center of the display device 100 (the Y1, Y2, Z1 and Z2 directions). The inner surface 122 is a surface facing inside the housing 2. That is, the inner surface 122 is the surface of the front housing 21 that is not visible to the user of the display device 100. In particular, the interior section is disposed within the interior space of the display device 100 such that the interior section does not expose outside of the display device 100 while the front housing 21 is attached to the rear housing 22.

The interior section (the inner surface 122) of the front housing 21 has a base surface portion 122a, a plurality of rib portions 122b, and a plurality of gate formation portions 122c.

The base surface portion 122a is a surface provided on the rear side of the exterior surface 121. The base surface portion 122a is substantially L-shaped cross-section. Specifically, the base surface portion 122a is substantially L-shaped as viewed in a cross-sectional view, as shown in FIG. 4. The base surface portion 122a has a frame shape. Specifically, the base surface portion 122a has a rear surface facing rearward (the X2 direction) and four inside surfaces facing inward relative to the center of the display device 100 (the Y1, Y2, Z1 and Z2 directions). The rear surface of the base surface portion 122a has horizontal edges extending along the Y direction and vertical edges extending along the Z direction.

The rib portions 122b have a flat shape. A plurality of (twenty-six in FIG. 3) rib portions 122b are provided to the base surface portion 122a. The rib portions 122b are arranged relative to each other along the base surface portion 122a. In particular, twelve rib portions 122b are arranged along each of the horizontal edges of the base surface portion 122a, while one rib portion 122b is arranged along each of the vertical edges of the base surface portion 122a. Of course, the number of the rib portions 122b that are arranged along the horizontal edges can be more than or less than twelve, while the number of the rib portions 122b that are arranged along the vertical edges can be more than one, as needed and/or desired. The rib portions 122b protrude from the base surface portion 122a (the inner surface 122) in the X2 direction (a direction substantially perpendicular to the base surface portion 122a). The rib portions 122b each extend in a specific direction (hereinafter referred to as a D direction). In particular, the rib portions 122b that are arranged along the horizontal edges of the base surface portion 122a each extend in the Y direction, while the rib portions 122b that are arranged along the vertical edges of the base surface portion 122a each extend in the Z direction. In the illustrated embodiment, the rib portions 122b are disposed spaced apart from the inside surfaces of the base surface portion 122a via a gap therebetween. The wall thickness Tr of the rib portions 122b is less than the average wall thickness between the exterior surface portion 121 and the base surface portion 122a. The wall thickness Tr of the rib portions 122b is preferably about 25% to about 35% of the average wall thickness between the exterior surface 121 and the base surface portion 122a. The rib portions 122b may be provided at 1 to 25 locations, or at 27 or more locations, on the base surface portion 122a.

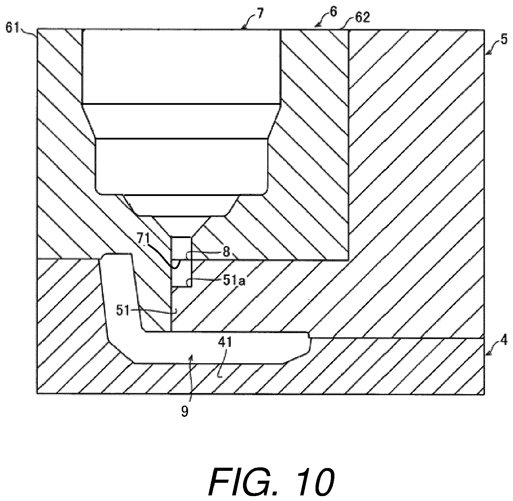

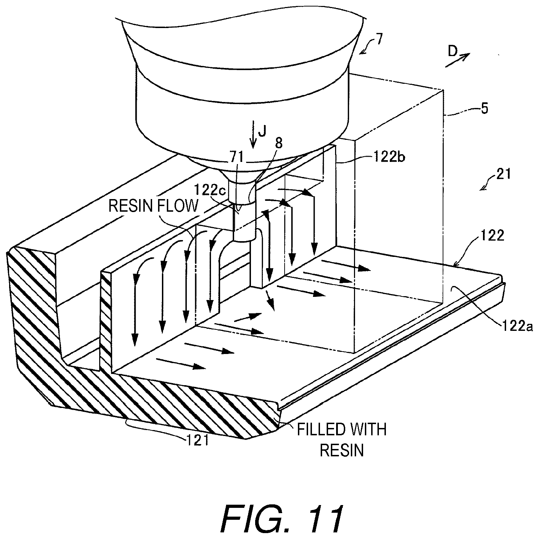

The gate formation portions 122c are formed while the resin front housing 21 is formed of the resin ejected from a resin ejection port 71 of a hot runner 7 (see FIG. 11). That is, the gate formation portions 122c are portions formed in order to form the front housing 21 by direct gate method using the hot runner 7. The gate formation portions 122c are substantially cylindrical. The gate formation portions 122c have a diameter that matches the diameter of the resin ejection port 71 (see FIG. 10) of the hot runner 7. Consequently, a resin injection gate 8 that comes into contact with the resin ejection port 71 of the hot runner 7 at the gate formation portions 122c has a diameter that matches the diameter of the resin ejection port 71 of the hot runner 7. The gate formation portions 122c extend along a direction parallel to the X2 direction (the direction in which the rib portions 122b protrude). The gate formation portions 122c are provided integrally with the rib portions 122b. A plurality of (twenty in FIG. 3) gate formation portions 122c are provided. The gate formation portions 122c may be provided at 1 to 19 locations, or at 21 or more locations. The hot runner 7 is a molding tool used for heating and melting the runner during injection molding. The resin ejection port 71 of the hot runner 7 is a nozzle tip of the hot runner 7, for example. Here, the resin injection gate 8 is a small opening in a mold or die through which the resin enters a cavity 9 (see FIG. 10) of the mold or die corresponding to the front housing 21. In the illustrated embodiment, the gate formation portions 122c each includes a first surface 122e and a second surface 122f oppositely facing away from the first surface 122e. Specifically, in the illustrated embodiment, the first surface 122e faces in the X2 direction, while the second surface 122f faces in the X1 direction. The first surface 122e also faces with the resin injection gate 8 while molding the front housing 21. Thus, the first surface 122e can include a gate vestige or witness mark. However, of course, the gate vestige can be removed from the first surface 122e after molding the front housing 21. Furthermore, in the illustrated embodiment, the hot runner 7 can be a runner system with a thermal gate function, a valve gated hot runner system, or any other system as needed and/or desired.

### Space Portion

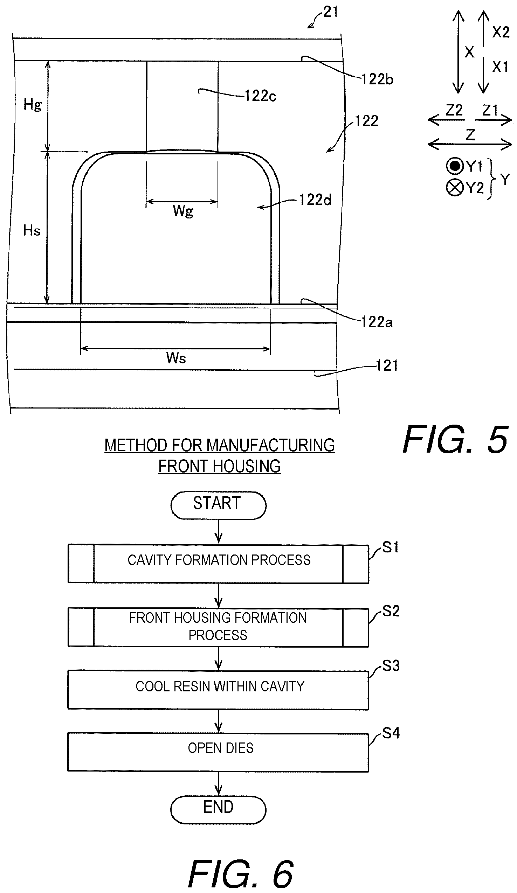

As shown in FIGS. 4 and 5, the front housing 21 in the first embodiment has space portions 122d formed between the gate formation portions 122c of the inner surface 122 and the exterior surface 121. That is, the gate formation portions 122c of the inner surface 122 and the exterior surface 121 are not directly integrated, but are integrated via the rib portions 122b. Thus, in the illustrated embodiment, the rib portions 122b that extend from the inner surface 122 and are connected to the gate formation portions 122c each have an aperture that forms the space portion 122d. In the illustrated embodiment, the second surfaces 122f of the gate formation portions 122c are disposed spaced apart from the exterior surface 121 and the inner surface 122 (the rear surface of the base surface portion 122a) via the space portions 122d, respectively. In particular, as shown in FIGS 4 and 5, the second surfaces 122f are disposed between the first surfaces 122e and the exterior surface 121 in the X direction in which the gate formation portions 122c extend. Also, as shown in FIGS 4 and 5, the second surfaces 122f are directly opposite the inner surface 122 (the rear surface of the base surface portion 122a) via the space portions 122d, respectively. Furthermore, the space portions 122d are disposed at locations corresponding to the gate formation portions 122c, respectively. Thus, in the illustrated embodiment, the number of the space portions 122d is the same as the number of the gate formation portions 122c (twenty in FIG. 3).

Referring to FIGS. 4 and 5, one of the space portions 122d that is located in a Z portion of the front housing 21 (see FIG. 3) is illustrated in more detail. In particular, one of the space portions 122d that is located on one of the vertical edges of the base surface portion 122a is illustrated in more detail. Since the constructions of the space portions 122d are the same, the description of the space portion 122d illustrated in FIGS. 4 and 5 also applies to the other space portions 122d. The space portion 122d has a substantially rounded rectangular shape when viewed from the Y1 direction (one direction in the thickness direction of the rib portion 122b). The space portion 122d is a through-hole that go through the rib portion 122b in the Y direction (the thickness direction of the rib portion 122b). In the Z direction (the width direction perpendicular to the direction in which the gate formation portion 122c extends), the width Ws of the space portion 122d is greater than the width Wg of the gate formation portion 122c. In the X direction (the direction in which the gate formation portion 122c extends), the height Hs of the space portion 122d is greater than the height Hg of the gate formation portion 122c. Also, in the Y direction (the thickness direction of the rib portion 122b), the thickness Ts of the space portion 122d is less than the average wall thickness between the exterior surface 121 and the base surface portion 122a, similarly to the thickness Tr of the rib portion 122b. The thickness Ts of the space portion 122d is preferably about 25% to about 35% of the average wall thickness between the exterior surface 121 and the base surface portion 122a. The shape of the space portion 122d may be semicircular or the like, and is not limited to a substantially round rectangular shape.

The end surface of the space portion 122d on the gate formation portion 122c side is a surface molded by a resin collision surface 51a of a flow changing section 51 of a slide die 5 (discussed below). This end surface of the space portion 122d includes the second surface 122f of the gate formation portion 122c and is a plane extending in the D direction. That is, the end surface is a plane extending in a direction perpendicular to a resin injection direction in which the resin is ejected from the resin ejection port 71 of the hot runner 7 (i.e., a resin ejection direction, hereinafter referred to as a J direction). Also, as shown in FIGS. 4 and 5, in the illustrated embodiment, the first surface 122e and the second surface 122f are disposed away from each other in the resin injection direction for molding the front housing 21. Thus, in the illustrated embodiment, the end surface of the space portion 122d that includes the second surface 122f of the gate formation portion 122c is formed as an undercut surface.

### Method for Manufacturing Front Housing

The method for manufacturing the front housing 21 as a resin molded article (e.g., the resin molded article manufacturing method) will be described with reference to FIGS. 6 to 15. The method for manufacturing the front housing 21 is a process of filling with resin so that no appearance defects (whitening, flow marks, etc.) occur on the exterior surface 121 of the front housing 21, without having to lengthen the molding cycle of the front housing 21 or increase the wall thickness of the front housing 21.

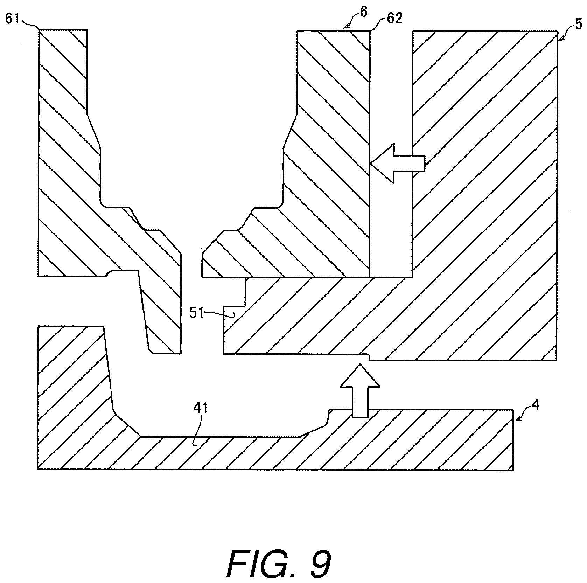

As shown in FIG. 6, a cavity forming process is performed in step S1. Specifically, in step S1, a plurality of resin molding dies (e.g., a movable die 4, a slide die 5, and a fixed die 6) are brought into contact with each other to form the cavity 9 having a shape corresponding to the front housing 21 (e.g., the resin molded article) (see FIGS. 9 and 10).

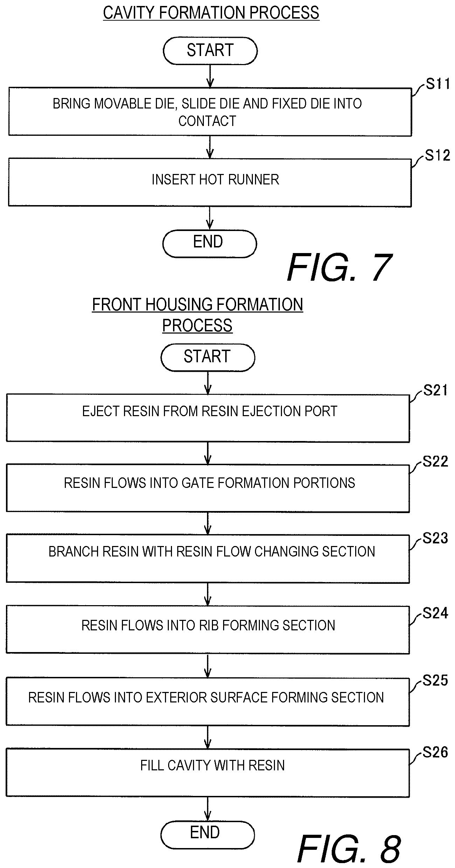

More specifically, in a subroutine of the cavity forming process shown in FIG. 7, step S1 of forming the cavity 9 includes a step S11 of bringing the movable die 4, the slide die 5 and the fixed die 6 into contact with each other (see FIGS. 9 and 10). In the illustrated embodiment, the movable die 4 is provided with an exterior surface forming section 41 that forms the exterior surface 121 of the front housing 21. The slide die 5 is provided with a flow changing section 51. Specifically, in the illustrated embodiment, the flow changing section 51 of the slide die 5 is provided to form the space portion 122d. Since the front housing 21 has the plurality of space portions 122d corresponding to the gate formation portion 122c, the slide die 5 can be provided with a plurality of flow changing sections 51 corresponding to the plurality of space portions 122d. In the illustrated embodiment, the slide die 5 can be divided into a plurality of die portions each having at least one flow changing sections 51 such that the die portions are slidable in different directions relative to the fixed die 6. Referring to FIGS. 9 to 14, one of the die portions of the slide die 5 that forms one of the space portions 122d is illustrated in more detail. Since the constructions of the die portions are the same with or similar to each other, the description of the die portion of the slide die 5 illustrated in FIGS. 9 to 14 also applies to the other die portions. Furthermore, referring to FIGS. 9 to 14, the method for manufacturing a portion of the front housing 21 using the die portion of the slide die 5 is illustrated. Since the constructions of the die portions are the same with or similar to each other, the description of the method for manufacturing a portion of the front housing 21 using the die portion of the slide die 5 illustrated in FIGS. 9 to 14 also applies to the method for manufacturing the entirety of the front housing 21 using the die portions of the slide die 5. In the illustrated embodiment, in a state in which a first fixed die 61 and a second fixed die 62 of the fixed die 6 have been installed, the movable die 4 and the slide die 5 (the die portions) move relative to the fixed die 6 until they hit the first fixed die 61 and the second fixed die 62.

In step S12, the hot runner 7 is inserted into the space formed by the first fixed die 61 and the second fixed die 62 (see FIG. 10). That is, the hot runner 7 moves into the space between the first fixed die 61 and the second fixed die 62 until the resin ejection port 71 of the hot runner 7 comes into contact with the resin injection gate 8. After the hot runner 7 has moved, the subroutine of the cavity forming process ends, and the process proceeds to step S2.

As shown in FIG. 6, in step S2, a front housing molding process is performed. That is, in step S2, the front housing 21 (the resin molded article) is formed by injecting resin directly from the resin ejection port 71 into the resin injection gate 8 and filling the cavity 9 with the resin (see FIG. 11).

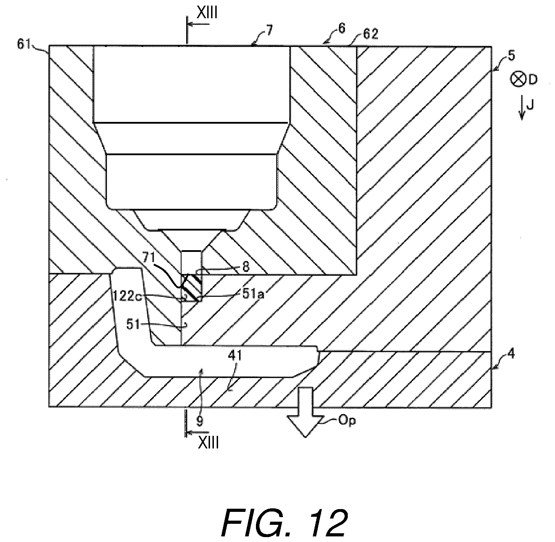

More specifically, in the subroutine of the front housing molding process shown in FIG. 8, step S2 of filling the cavity 9 with resin to mold the front housing 21 includes steps S21 to S26 of filling the cavity 9 with the resin while changing the flow of the resin headed directly toward the cavity 9 from the resin injection gate 8 by the resin flow changing section 51 of the slide die 5 provided opposite the resin injection gate 8 (see FIGS. 11 and 12). In particular, in step S2 of forming the front housing 21, the cavity 9 is filled with resin while the flow of resin is being changed by the resin flow changing section 51 having a resin collision surface 51a when the flow of resin hits the resin collision surface 51a opposite the resin injection gate 8. Here, the resin flow changing section 51 is a distal end portion of the slide die 5 and is located between the gate formation portion 122c and an exterior surface forming section 41 of the movable die 4 that forms the exterior surface 121 of the resin molded article when the cavity 9 is filled with the resin. The resin collision surface 51a is a flat surface extending in the D direction. That is, the resin collision surface 51a is a plane extending in a direction perpendicular to the J direction (the resin ejection direction) of the resin that is being ejected from the resin ejection port 71 of the hot runner 7. The resin collision surface 51a is opposite the resin injection gate 8 in the J direction. More specifically, the resin collision surface 51a is opposite the resin injection gate 8 in an Op direction (i.e., a die opening direction of the movable die 4).

In step S21, the resin is ejected from the resin ejection port 71 of the hot runner 7. Consequently, the resin is injected from the resin injection gate 8 (see FIG. 12). In step S22, the resin flows into the gate formation portion 122c. That is, in step S22, by making the resin flow toward the resin flow changing section 51, the gate formation portion 122c is formed between the resin flow changing section 51 and the resin injection gate 8 as a non-exterior portion on the inside of the front housing 21. Here, the non-exterior portion of the front housing 21 is a portion that is disposed inside of the front housing 21 and does not expose outside of the front housing 21 while the front housing 21 is attached to the rear housing 22.

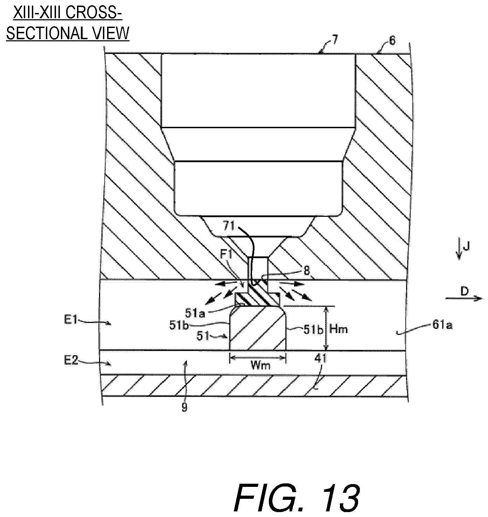

In step S23, the resin is branched by the resin flow changing section 51 (see FIG. 13). At this time, the flow of the resin ejected from the resin ejection port 71 is changed to a direction substantially perpendicular to the J direction by the resin flow changing section 51. Step S23 is a step of branching the resin by changing the resin injected from the resin injection gate 8 with the resin flow changing section 51 of the slide die 5. That is, in step S23, the resin flow changing section 51 branches the flow of the resin injected from the resin injection gate 8. More specifically, in step S23, the resin flow changing section 51 branches the flow of the resin injected from the resin injection gate 8 in two directions intersecting the J direction of the resin injected from the resin injection gate 8. In particular, in step S23, the resin collision surface 51a branches the flow of the resin injected from the resin injection gate 8 in two directions intersecting the J direction of the resin injected from the resin injection gate 8.

Also, in step S23, the cavity 9 is filled with resin while the flow of resin headed directly toward the cavity 9 from the resin injection gate 8 is changed by the resin flow changing section 51 in a state in which the slide die 5 provided with the resin flow changing section 51 having the width Wm greater than the width Wg of the gate formation portion 122c in the direction perpendicular to the J direction is disposed relative to the fixed die 6 and the movable die 4 (see FIGS. 5 and 13). That is, the flow of the resin injected from the resin injection gate 8 conforms to the shape of the resin collision surface 51a of the resin flow changing section 51 of the slide die 5, which is perpendicular to the J direction. At this time, the resin injected from the resin injection gate 8 is diverted by the width Wm of the resin flow changing section 51 of the slide die 5 in a direction perpendicular to the J direction and flows toward the exterior surface forming section 41. That is, the resin injected from the resin injection gate 8 flows into bypass flow paths F1 (spaces) that form parts of the rib portions 122b in the cavity 9.

Also, in step S23, the cavity 9 is filled with resin while the flow of the resin headed directly toward the cavity 9 from the resin injection gate 8 is changed by the resin flow changing section 51 in a state in which the slide die 5 provided with the resin flow changing section 51 having the height Hm greater than the height Hg of the gate formation portion 122c in the J direction is disposed relative to the fixed die 6 and the movable die 4 (see FIGS. 5 and 13). That is, the resin injected from the resin injection gate 8 flows along the resin collision surface 51a of the resin flow changing section 51, and then flows into spaces E1 that form the rib portions 122b in the cavity 9. At this time, the resin injected from the resin injection gate 8 also flows along a surface 51b of the resin flow changing section 51 that extends in the J direction. The resin injected from the resin injection gate 8 then flows down toward the exterior surface forming section 41 by the height Hm of the resin flow changing section 51 of the slide die 5 in the J direction. That is, the resin injected from the resin injection gate 8 flows down from the spaces E1 in the cavity 9 that form the rib portions 122b toward a space E2 in the cavity 9 that forms the exterior surface 121.

Also, the resin injected from the resin injection gate 8 flows along the resin collision surface 51a of the resin flow changing section 51 of the slide die 5 that is perpendicular to the J direction within a path that is narrowed by the height Hm of the resin flow changing section 51 of the slide die 5 in the J direction.

In step S24, the resin flows into a rib forming section 61a of the first fixed die 61 that forms the rib portion 122b of the front housing 21 (see FIGS. 11 and 13). At this time, in step S24, the resin flows in by being branched off by the resin flow changing section 51 both toward one side along the D direction (the specific direction) of the rib portion 122b, which serve as a non-exterior portion extending in the D direction, and toward the other side that is in the opposite direction from the D direction. The resin injected from the resin injection gate 8 flows so as to fill a portion of the cavity 9 corresponding to the rib forming section 61a and a portion of the cavity 9 corresponding to the exterior surface forming section 41.

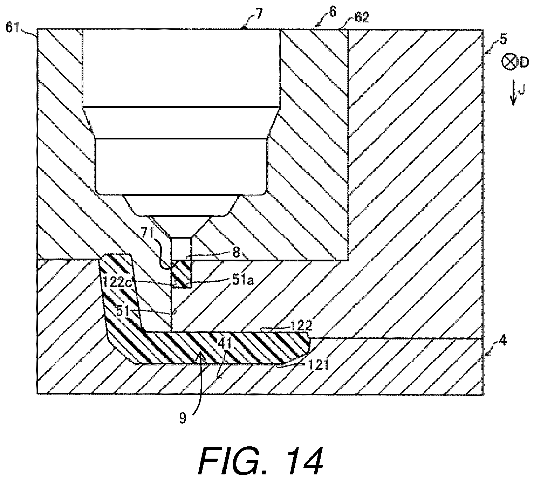

In step S25, the resin flows into the portion of the cavity 9 corresponding to the exterior surface forming section 41 (see FIG. 14). Then, in step S26, after the cavity 9 is filled with the resin, the process proceeds to step S3. In this way, the resin fills the cavity 9 by flowing into a portion of the cavity 9 corresponding to the gate formation portion 122c, a portion of the cavity 9 corresponding to the rib forming section 61a, and a portion of the cavity 9 corresponding to the exterior surface forming section 41, in this order.

In step S3, the resin in the cavity 9 is cooled. After the resin has cooled, the front housing 21 (the resin molded article) is taken out by opening the die in step S4.

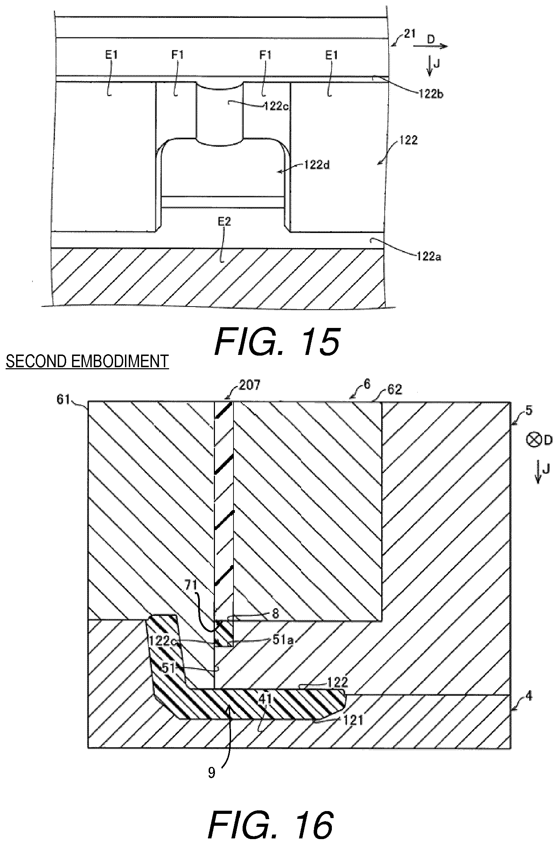

The result of performing the method for manufacturing the front housing 21 as described above is that the front housing 21 is formed in which the space portions 122d are formed between the gate formation portions 122c and the exterior surface 121 as shown in FIG. 15.

Here, the gate formation portions 122c of the front housing 21 are formed by filling the spaces formed by the slide die 5 and the first fixed die 61 in the cavity 9 with resin. Of the rib portions 122b of the front housing 21, portions that are adjacent to the gate formation portion 122c side of the space portions 122d are formed by filling the bypass flow paths F1 (spaces) formed in the cavity 9 by the resin flow changing section 51 of the slide die 5 and the first fixed die 61 with the resin.

Also, portions of the rib portions 122b in the front housing 21 in which the space portions 122d are not formed are formed in the cavity 9 by filling the spaces E1 formed by portions of the slide die 5 other than the resin flow changing section 51, by the first fixed die 61, and by the second fixed die 62 with the resin. In the cavity 9, the portion of the front housing 21 forming the exterior section having the exterior surface 121 is formed by filling the space E2 formed by the slide die 5, by the second fixed die 62, and by the movable die 4.

The spaces E1 allow the bypass flow paths F1 to communicate with the space E2. The volume of the spaces E1 is greater than that of the bypass flow paths F1. The volume of the space E2 is greater than the volume of the spaces E1.

In this way, the housing 2 (particularly the front housing 21) of the display device 100 is formed as a resin molded article.

### Effect of First Embodiment

The first embodiment has the following effect.

In the first embodiment, as described above, in step S2 of molding the front housing 21, steps S21 to S26 are provided in which the cavity 9 is filled with resin while the flow of the resin that is headed directly toward the cavity 9 from the resin injection gate 8 is changed by the resin flow changing section 51 that is provided opposite the resin injection gate 8. Consequently, the resin ejected from the resin ejection port 71 hits the opposing resin flow changing section 51, which changes the resin flow. Thus, when the resin ejected from the resin ejection port 71 reaches the exterior surface 121, the resin will have less momentum as compared to a case in which the ejected resin directly reaches the exterior surface 121, and therefore rebound of the resin can be reduced in the cavity 9. Therefore, the cavity 9 can be filled with resin while reducing unevenness in the density of the resin in the cavity 9, so there will be fewer appearance defects, such as whitening of the exterior surface 121 due to the difference in the shrinkage of the resin, or the appearance of a pattern on the exterior surface 121 that matches the rebound flow of the resin. As a result, appearance defects can be reduced by the resin flow changing section 51 without changing the molding conditions. Also, the resin flow changing section 51 will reduce appearance defects even when the resin ejection speed is increased (when the resin temperature is raised to reduce the viscosity), so the molding cycle can be shortened in a state of reducing appearance defects.

Also, in the first embodiment, as described above, steps S21 to S26 of filling with the resin are provided with step S23 in which the flow of the resin injected from the resin injection gate 8 is branched by the resin flow changing section 51. With this configuration, the amount of resin can be dispersed by branching the resin flow, so the kinetic energy of each branched resin flow can be reduced as compared to the original resin flow. As a result, the momentum of the flow of each branched resin can be reduced as compared with the original resin flow, so the rebounding of the resin in the cavity 9 can be further suppressed.

Also, in the first embodiment, as described above, steps S21 to S26 of filling with the resin are provided with step S23 in which the resin flow changing section 51 branches the flow of the resin that is injected from the resin injection gate 8 into two directions intersecting the J direction of the resin injected from the resin injection gate 8. With this configuration, every time the branching of the resin flow is increased, the amount of resin can be dispersed by the amount of the increase in the branching of the resin flow. Therefore, the kinetic energy of each branched resin flow can be further reduced as compared with the original resin flow, by the amount in which the branching of the resin flow is increased. As a result, the momentum of each branched resin flow can be further reduced as compared with the original resin flow, so the rebounding of the resin within the cavity 9 can be further suppressed.

Also, in the first embodiment, as described above, step S1 of forming the cavity 9 is provided with step S11 in which the movable die 4 provided with the exterior surface forming section 41 that forms the exterior surface 121 of the front housing 21, the slide die 5 provided with the resin flow changing section 51, and the fixed die 6 are brought into contact with each other. Step S23 of branching the resin flow is provided with step S23 in which the resin is branched by changing the flow of the resin that is injected from the resin injection gate 8 by the resin flow changing section 51 of the slide die 5. With this configuration, the resin flow changing section 51 is provided to the slide die 5 that is separate from the fixed die 6 and the movable die 4. Thus, the slide die 5 can be slid to remove the resin flow changing section 51 from the front housing 21 when the front housing 21 is parted from the die, so the front housing 21 can be easily parted from the die without being caught by the resin flow changing section 51.

Also, in the first embodiment, as described above, step S2 of forming the front housing 21 is provided with step S21 in which the resin is injected from the resin injection gate 8, and step S22 in which the gate formation portions 122c, as the non-exterior portions, are formed inside of the front housing 21 between the resin flow changing section 51 and the resin injection gate 8 by making the resin flow toward the resin flow changing section 51. With this configuration, even if rebound occurs at the gate formation portions 122c, there will be no appearance defects in the front housing 21 because the gate formation portions 122c are the non-exterior portions, so the appearance of the front housing 21 can be kept good.

Also, in the first embodiment, as described above, steps S21 to S26 of filling with the resin include step S23 in which the cavity 9 is filled with the resin while changing the flow of the resin that is headed directly from the resin injection gate 8 toward the cavity 9 by the resin flow changing section 51 in a state in which the slide die 5, which is provided with a resin flow changing section 51 having the width Wm that is greater than the width Wg of the gate formation portions 122c in the direction perpendicular to the J direction, is attached to the movable die 4 and the fixed die 6. With this configuration, the resin flow toward the exterior surface forming section 41 after branching can be diverted by the width Wm of the resin flow changing section 51, so the momentum of the resin flow after branching can be further reduced.

Also, in the first embodiment, as described above, steps S21 to S26 of filling with the resin include step S23 in which the cavity 9 is filled with the resin while changing the flow of the resin that is headed directly from the resin injection gate 8 toward the cavity 9 by the resin flow changing section 51 in a state in which the slide die 5, which is provided with the resin flow changing section 51 having the height Hm that is greater than the height Hg of the gate formation portions 122c in the J direction, is attached to the movable die 4 and the fixed die 6. With this configuration, the length of the flow path of the resin going toward the exterior surface forming section 41 after branching can be increased by the height Hm of the resin flow changing section 51, so the momentum of the resin flow after branching can be further reduced.

Also, in the first embodiment, as described above, steps S21 to S26 of filling the cavity 9 with the resin include step S24 in which the resin flow changing section 51 branches the resin both toward one side along the D direction of the rib portions 122b, as the non-exterior portions, that extends in the D direction, and toward the other side that is in the opposite direction from the D direction. With this configuration, the rib portions 122b can be used to branch the resin flow, so the structure of the resin molding die can be less complex than when a dedicated structure is provided for branching the resin flow.

Also, in the first embodiment, as described above, step S2 of forming the front housing 21 is provided with steps S21 to S26 in which the housing 2 of the display device 100 is formed as the front housing 21. With this configuration, the housing 2 of the display device 100 with fewer appearance defects can be obtained by the resin flow changing section 51 without changing the molding conditions.

Also, in the first embodiment, as described above, the space portions 122d are formed between the gate formation portions 122c on the inner surface 122 and the exterior surface 121 by filling the cavity 9 with the resin while changing the flow of the resin by the resin flow changing section 51. With this configuration, the resin ejected from the resin ejection port 71 hits the opposing resin flow changing section 51, which changes the resin flow. This reduces the momentum of the resin ejected from the resin ejection port 71, so the rebound of the resin inside the cavity 9 can be reduced. Therefore, the cavity 9 can be filled with the resin in a state in which there is less unevenness in the density of the resin in the cavity 9, so there are fewer appearance defects, such as whitening of the exterior surface 121 due to the difference in the shrinkage of the resin, or the appearance of a pattern on the exterior surface 121 that matches the rebounded resin flow, etc. As a result, the display device 100 with fewer appearance defects can be obtained merely by forming the space portions 122d by the resin flow changing section 51 without changing the molding conditions.

Also, in the first embodiment, as described above, the width Ws of the space portions 122d is made greater than the width Wg of the gate formation portions 122c in the Z direction (the width direction perpendicular to the direction in which the gate formation portions 122c extend). With this configuration, the resin flow changing section 51 that matches the space portion 122d with the above-mentioned width Ws can divert the flow of the resin toward the exterior surface forming section 41 after branching by the width Wm of the resin flow changing section 51, so the momentum of the resin flow after branching can be further reduced.

Also, in the first embodiment, as described above, the height Hs of the space portions 122d is made larger than the height Hg of the gate formation portions 122c in the X direction (the direction in which the gate formation portions 122c extend). With this configuration, the resin flow changing section 51 that matches the space portion 122d with the above-mentioned height Hs can increase the length of the flow path of the resin toward the exterior surface forming section 41 after branching by the height Hm of the resin flow changing section 51, so the momentum of the resin flow after branching can be further reduced.

### SECOND EMBODIMENT

Referring now to FIGS. 1, 2 and 16, a method for manufacturing the front housing 21 of the display device 100 according to a second embodiment will now be explained. In view of the similarity between the first and second embodiments, the parts of the second embodiment that are identical to the parts of the first embodiment will be given the same reference numerals as the parts of the first embodiment. Moreover, the descriptions of the parts of the second embodiment that are identical to the parts of the first embodiment may be omitted for the sake of brevity.

In this second embodiment, unlike the first embodiment, the cavity 9 is filled with resin through a cold runner 207. Components that are the same as in the first embodiment will not be described again in the second embodiment.

As shown in FIGS. 1 and 2, the display device 100 in the second embodiment comprises the display module 1, the housing 2, and the rear cover 3. The housing 2 includes the front housing 21 and the rear housing 22. The front housing 21 is an example of the "housing" in the present disclosure.

### Front Housing

The front housing 21 will be described in detail.

The front housing 21 has the exterior section with the exterior surface 121 and the interior section with the inner surface 122. The inner surface 122 has the base surface portion 122a, the rib portions 122b, and the gate formation portions 122c.

The gate formation portions 122c in the second embodiment are formed when the front housing 21 made of resin is molded from resin. In the illustrated embodiment, the resin is ejected or dispensed from a nozzle (not shown) and conveyed through the resin ejection port 71 of the cold runner 207 into the cavity 9 corresponding to the front housing 21. Thus, the front housing 21 is molded from the resin injected through the resin ejection port 71 of the cold runner 207. The cold runner 207 is an unheated channel used to convey the resin while the runner is cooled during the injection molding process. In the illustrated embodiment, the cold runner 207 is a channel formed in the fixed die 6. As shown in FIG. 16, the resin is filled into the cavity 9 through the cold runner 207, and thus the resin within the cold runner 207 is connected to the resin within the cavity 9 through the resin injection gate 8 during the injection molding process. The resin within the cold runner 207 is separated and removed from the front housing 21 at the resin injection gate 8 after the injection molding process. Here, in the illustrated embodiment, the resin within the cold runner 207 is illustrated with different hatching from the resin within the cavity 9 to clearly show the front housing 21, but is formed from the same resin within the cavity 9. Also, in the illustrated embodiment, the gate type of the cold runner 207 can be any type, such as a direct gate, a side gate, a tab gate, a fan gate, a submarine gate, a banana gate, a point gate, as needed and/or desired. The rest of the configuration of the second embodiment is the same as in the first embodiment.

### Effect of Second Embodiment

In the second embodiment, just as in the first embodiment, step S2 of forming the front housing 21 includes steps S21 to S26 in which the cavity 9 is filled with the resin while changing the flow of the resin that is headed directly toward the cavity 9 from the resin injection gate 8 by the resin flow changing section 51, which is provided opposite the resin injection gate 8. Consequently, appearance defects can be reduced by the resin flow changing section 51 without changing the molding conditions. The other effects of the second embodiment are the same as those in the first embodiment.

### THIRD EMBODIMENT

Referring now to FIGS. 1, 2, 17 and 18, a method for manufacturing the front housing 21 of the display device 100 according to a third embodiment will now be explained. In view of the similarity between the first and third embodiments, the parts of the third embodiment that are identical to the parts of the first embodiment will be given the same reference numerals as the parts of the first embodiment. Moreover, the descriptions of the parts of the third embodiment that are identical to the parts of the first embodiment may be omitted for the sake of brevity.

In this third embodiment, unlike the first embodiment, a plurality of rib portions 320 are formed.

As shown in FIGS. 1 and 2, the display device 100 in the third embodiment comprises the display module 1, the housing 2, and the rear cover 3. The housing 2 includes the front housing 21 and the rear housing 22. The front housing 21 is an example of the "housing" in the present disclosure.

### Front Housing

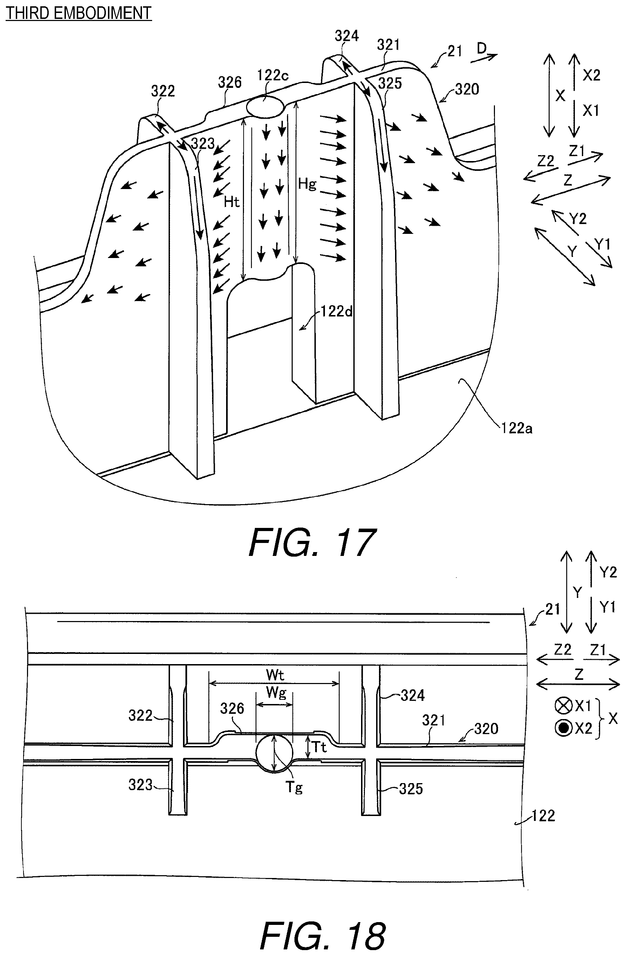

As shown in FIGS. 17 and 18, the front housing 21 has the exterior section with the exterior surface 121 and the interior section with the inner surface 122. The inner surface 122 has the base surface portion 122a, the rib portions 320, and the gate formation portions 122c.

The rib portions 320 each have a main rib portion 321, a first sub-rib portion 322, a second sub-rib portion 323, a third sub-rib portion 324, a fourth sub-rib portion 325, and a thick portion 326.

The main rib portion 321 has a flat shape. The main rib portion 321 protrudes from the base surface portion 122a in the X2 direction (a direction substantially perpendicular to the base surface portion 122a). The main rib portion 321 extends in a specific direction (hereinafter referred to as the D direction). The thickness of the main rib portion 321 is less than the average thickness between the exterior surface 121 and the base surface portion 122a. The thickness of the main rib portion 321 is preferably about 25% to about 35% of the average thickness between the exterior surface 121 and the base surface portion 122a.

Since each of the first to fourth sub-rib portions 322 to 325 has the same structure, only the first sub-rib portion 322 will be described.

The first sub-rib portion 322 has a flat shape. The first sub-rib portion 322 protrudes from the base surface portion 122a in the X2 direction (a direction substantially perpendicular to the base surface portion 122a). The first sub-rib portion 322 extends in a direction perpendicular to the D direction. The thickness of the first sub-rib portion 322 is less than the average thickness between the exterior surface 121 and the base surface portion 122a. The thickness of the first sub-rib portion 322 is preferably about 25% to about 35% of the average thickness between the exterior surface 121 and the base surface portion 122a.

The thick portion 326 is a portion of the main rib portion 321 having a thickness Tt that is greater than that of the other portions. The thick portion 326 is provided at a position adjacent to the space portion 122d in the main rib portion 321. The width Wt of the thick portion 326 is greater than the width Wg of the gate formation portion 122c in the Z direction (the width direction, perpendicular to the direction in which the gate formation portion 122c extends). The height Ht of the thick portion 326 is substantially the same as the height Hg of the gate formation portion 122c in the X direction (the direction in which the gate formation portions 122c extends). The thickness Tt of the thick portion 326 is less than the thickness Tg of the gate formation portion 122c in the Y direction (the thickness direction, perpendicular to the direction in which the gate formation portion 122c extends). The rest of the configuration in the third embodiment is the same as in the first embodiment.

### Effect of Third Embodiment

In the third embodiment, just as in the first embodiment, step S2 of forming the front housing 21 includes steps S21 to S26 in which the cavity 9 is filled with the resin while changing the flow of the resin that is headed directly toward the cavity 9 from the resin injection gate 8 by the resin flow changing section 51, which is provided opposite the resin injection gate 8. Consequently, appearance defects can be reduced by the resin flow changing section 51 without changing the molding conditions.

Also, in the third embodiment, as described above, not only the main rib portion 321, but also the first to fourth sub-rib portions 322 to 325 are provided, which further branches the resin flow as compared to when only the main rib portion 321 is provided, so appearance defects can be further reduced. Also, since the flow of the resin can be further branched, appearance defects can be reduced even when the resin ejection speed is increased (when the resin temperature is raised to reduce the viscosity), so the molding cycle can be further shortened in a state in a state of reducing appearance defects. The other effects of the third embodiment are the same as those of the first embodiment.

### MODIFICATION EXAMPLES

The embodiments disclosed here are illustrative and are not restrictive in all respects. The scope of the invention is indicated by the claims rather than by the description of the embodiments described above, and furthermore includes all modifications (modification examples) within the meaning and scope of the claims.

For example, in the first to third embodiments, an example is shown in which the resin molded article is the front housing 21 of the display device 100, but the present invention is not limited to this. In the present invention, the resin molded article can be a resin molded article other than parts of the display device.

Also, in the first to third embodiments, an example is shown in which the flow of the resin injected from the resin injection gate 8 is branched in two directions intersecting the J direction (the resin injection direction) by the resin flow changing section 51, but the present invention is not limited to this. In the present invention, the flow of the resin injected from the resin injection gate can be branched in three or more directions.

Also, in the first to third embodiments, an example is given in which the gate formation portions 122c are formed in the rib portions 122b that are formed as the non-exterior portions, but the present invention is not limited to this. In the present invention, the gate formation portions can be formed in a non-exterior portion other than the rib portions, or in an exterior portion.

Further, in the first to third embodiments, an example is shown in which the width Wm of the resin flow changing sections 51 is greater than the width Wg of the gate formation portions 122c, but the present invention is not limited to this. In the present invention, the resin flow changing sections can have a width equal to or less than the width of the gate formation portions.

Also, in the first to third embodiments, an example is shown in which the height Hm of the resin flow changing sections 51 is greater than the height Hg of the gate formation portions 122c, but the present invention is not limited to this. In the present invention, the resin flow changing sections can have a height equal to or less than the height of the gate formation portions.

Also, in the first to third embodiments, an example is shown in which the width Ws of the space portions 122d is greater than the width Wg of the gate formation portions 122c, but the present invention is not limited to this. In the present invention, the width of the space portions can be equal to or less than the width of the gate formation portions.

Also, in the first to third embodiments, an example is shown in which the height Hs of the space portions 122d is greater than the height Hg of the gate formation portions 122c, but the present invention is not limited to this. In the present invention, the height of the space portions can be equal to or less than that of the gate formation portions.

Also, in the first to third embodiments, an example is shown in which the resin is injected into the cavity 9 through the resin injection gate 8 corresponding to the first surface 122e of the gate formation portion 122c, but the present invention is not limited to this. In the present invention, the resin injection gate can be provided at a location corresponding to a side surface of the gate formation portion 122c facing inward or outward (i.e., the Y1, Y2, Z1 and Z2 directions) with respect to the center of the display device 100. Since the rib portions 122b are disposed spaced apart from the inside surfaces of the base surface portion 122a and the outside surface of the exterior surface 121 via a gap (e.g., a space portion) therebetween, as shown in FIG. 4, even if the resin is injected into the cavity 9 from a location corresponding to an inside surface of the gate formation portion 122c facing inward, no appearance defects occur on the exterior surface 121. In this case, a surface of the rib portion 122b facing rearward (the X2 direction) can be kept flat without a gate vestige. Also, in this case, the rib portion 122b can be formed without the space portion 122d.

In understanding the scope of the present invention, the term "comprising" and its derivatives, as used herein, are intended to be open ended terms that specify the presence of the stated features, elements, components, groups, integers, and/or steps, but do not exclude the presence of other unstated features, elements, components, groups, integers and/or steps. The foregoing also applies to words having similar meanings such as the terms, "including", "having" and their derivatives. Also, the terms "part," "section," "portion," "member" or "element" when used in the singular can have the dual meaning of a single part or a plurality of parts unless otherwise stated.

As used herein, the following directional terms "forward", "rearward", "front", "rear", "up", "down", "above", "below", "upward", "downward", "top", "bottom", " side", "vertical", "horizontal", "perpendicular" and "transverse" as well as any other similar directional terms refer to those directions of a display device in an upright position. Accordingly, these directional terms, as utilized to describe the display device should be interpreted relative to a display device in an upright position on a horizontal surface. The terms "left" and "right" are used to indicate the "right" when referencing from the right side as viewed from the front of the display device, and the "left" when referencing from the left side as viewed from the front of the display device.

Also it will be understood that although the terms "first" and "second" may be used herein to describe various components these components should not be limited by these terms. These terms are only used to distinguish one component from another. Thus, for example, a first component discussed above could be termed a second component and vice-a-versa without departing from the teachings of the present invention. The term "attached" or "attaching", as used herein, encompasses configurations in which an element is directly secured to another element by affixing the element directly to the other element; configurations in which the element is indirectly secured to the other element by affixing the element to the intermediate member(s) which in turn are affixed to the other element; and configurations in which one element is integral with another element, i.e. one element is essentially part of the other element. This definition also applies to words of similar meaning, for example, "joined", "connected", "coupled", "mounted", "bonded", "fixed" and their derivatives. Finally, terms of degree such as "substantially", "about" and "approximately" as used herein mean an amount of deviation of the modified term such that the end result is not significantly changed.

While only selected embodiments have been chosen to illustrate the present invention, it will be apparent to those skilled in the art from this disclosure that various changes and modifications can be made herein without departing from the scope of the invention as defined in the appended claims. For example, unless specifically stated otherwise, the size, shape, location or orientation of the various components can be changed as needed and/or desired so long as the changes do not substantially affect their intended function. Unless specifically stated otherwise, components that are shown directly connected or contacting each other can have intermediate structures disposed between them so long as the changes do not substantially affect their intended function. The functions of one element can be performed by two, and vice versa unless specifically stated otherwise. The structures and functions of one embodiment can be adopted in another embodiment. It is not necessary for all advantages to be present in a particular embodiment at the same time. Every feature which is unique from the prior art, alone or in combination with other features, also should be considered a separate description of further inventions by the applicant, including the structural and/or functional concepts embodied by such feature(s). Thus, the foregoing descriptions of the embodiments according to the present invention are provided for illustration only, and not for the purpose of limiting the invention as defined by the appended claims.

## Claims

1. A resin molded article manufacturing method comprising:
forming a cavity having a shape corresponding to a resin molded article by bringing a plurality of resin molding dies into contact with each other; and
forming the resin molded article by ejecting a resin directly from a resin ejection port into a resin injection gate and filling the cavity with the resin,
the forming of the resin molded article including filling the cavity with the resin while changing a flow of the resin that is headed from the resin injection gate directly toward the cavity by a resin flow changing section that is provided opposite the resin injection gate.

2. The resin molded article manufacturing method according to claim 1,
wherein
the filling of the cavity with the resin includes branching the flow of the resin that is injected from the resin injection gate by the resin flow changing section.

3. The resin molded article manufacturing method according to claim 1 or 2, wherein
the filling of the cavity with the resin includes branching the flow of the resin that is injected from the resin injection gate in two or more directions,
the two or more directions intersect a resin injection direction of the resin that is injected from the resin injection gate by the resin flow changing section.

4. The resin molded article manufacturing method according to claim 2 or 3, wherein
the forming of the cavity includes bringing a movable die provided with an exterior surface forming section that is configured to mold an exterior surface of the resin molded article, a slide die provided with the resin flow changing section, and a fixed die into contact with each other, and
the branching of the flow of the resin includes branching the resin by changing the flow of the resin that is injected from the resin injection gate by the resin flow changing section of the slide die.

5. The resin molded article manufacturing method according to claim 4, wherein
the forming of the resin molded article includes injecting the resin from the resin injection gate, and
forming a gate formation portion between the resin flow changing section and the resin injection gate, as a non-exterior portion that is disposed inside of the resin molded article, by making the resin flow toward the resin flow changing section.

6. The resin molded article manufacturing method according to claim 4 or 5, wherein
the filling of the cavity with the resin further includes filling the cavity with the resin while changing the flow of the resin that is headed from the resin injection gate directly toward the cavity by the resin flow changing section in a state in which the slide die is attached to the movable die and the fixed die, with the resin flow changing section of the slide die having a width that is greater than a width of the gate formation portion in a direction perpendicular to a resin injection direction of the resin.

7. The resin molded article manufacturing method according to any one of claims 4 to 6, wherein
the filling of the cavity with the resin further includes filling the cavity with the resin while changing the flow of the resin that is headed from the resin injection gate directly toward the cavity by the resin flow changing section in a state in which the slide die is attached to the movable die and the fixed die, with the resin flow changing section of the slide die having a height that is greater than a height of the gate formation portion in a resin injection direction of the resin.

8. The resin molded article manufacturing method according to any one of claims 1 to 7, wherein
the filling of the cavity with the resin further includes branching the resin both toward one side along a specific direction of a rib portion that is formed as a non-exterior portion and extends in the specific direction, and toward the other side that is in an opposite direction from the specific direction by the resin flow changing section.

9. The resin molded article manufacturing method according to any one of claims 1 to 8, wherein
the forming of the resin molded article includes forming a housing of a display device as the resin molded article.

10. A display device comprising:
a display module including a display that is configured to display images; and
a resin housing holding the display module,
the resin housing including
an exterior section with an exterior surface facing outside of the resin housing, and
an interior section with an inner surface facing inside of the resin housing,
the interior section having a gate formation portion with a first surface and a second surface oppositely facing away from the first surface, the second surface of the gate formation portion being disposed spaced apart from the exterior surface via a space portion of the resin housing.

11. The display device according to claim 10, wherein
the second surface is disposed between the first surface and the exterior surface in a direction in which the gate formation portion extends.

12. The display device according to claim 10 or 11, wherein
the interior section has a rib portion that extends from the inner surface and is connected to the gate formation portion, the rib portion having an aperture that forms the space portion of the resin housing.

13. The display device according to any one of claims 10 to 12, wherein the second surface includes an undercut surface.

14. The display device according to any one of claims 10 to 13, wherein the space portion of the resin housing has a width that is greater than a width of the gate formation portion in a width direction perpendicular to a direction in which the gate formation portion extends.

15. The display device according to any one of claims 10 to 14, wherein the space portion of the resin housing has a height that is greater than a height of the gate formation portion in a direction in which the gate formation portion extends.
